(19) Europäisches Patentamt
European Patent Office
Office européen des brevets

(11) **EP 1 302 955 B1**

(12) **FASCICULE DE BREVET EUROPEEN**

(45) Date de publication et mention
de la délivrance du brevet:
**30.07.2008 Bulletin 2008/31**

(51) Int Cl.:
*H01F 41/04* *(2006.01)*
*H01L 21/02* *(2006.01)*
*H01F 17/00* *(2006.01)*
*H01L 23/64* *(2006.01)*

(21) Numéro de dépôt: **02354158.4**

(22) Date de dépôt: **09.10.2002**

(54) **Inductance et son procédé de fabrication**

Induktor und Verfahren zu seiner Herstellung

Inductance and its manufacturing method

(84) Etats contractants désignés:
**DE FR GB IT**

(30) Priorité: **10.10.2001 FR 0113055**

(43) Date de publication de la demande:
**16.04.2003 Bulletin 2003/16**

(73) Titulaire: **STMicroelectronics S.A.**
**92120 Montrouge (FR)**

(72) Inventeurs:
• **Gardes, Pascal**
**37100 Tours (FR)**
• **Auriel, Gérard**
**37390 Chanceaux-sur-Choisille (FR)**

(74) Mandataire: **de Beaumont, Michel**
**Cabinet Michel de Beaumont**
**1, rue Champollion**
**38000 Grenoble (FR)**

(56) Documents cités:
EP-A- 0 551 735     EP-A- 0 716 434
EP-A- 0 932 204     EP-A- 1 054 417
US-A1- 2001 017 395

• **PATENT ABSTRACTS OF JAPAN vol. 1999, no. 02, 26 février 1999 (1999-02-26) & JP 10 303037 A (FUJI ELECTRIC CO LTD), 13 novembre 1998 (1998-11-13)**
• **"METHOD FOR INDUCTIVE COIL FABRICATION" RESEARCH DISCLOSURE, KENNETH MASON PUBLICATIONS, HAMPSHIRE, GB, no. 440, décembre 2000 (2000-12), page 2226 XP001052540 ISSN: 0374-4353**

**Description**

La présente invention concerne un procédé de fabrication d'une inductance dans un circuit monolithique. Plus précisément, elle concerne la fabrication d'une inductance dans un circuit monolithique intégrant un nombre limité d'éléments passifs, du type inductance, résistance, condensateur, et éventuellement un nombre limité d'éléments actifs, tels qu'une diode de protection.

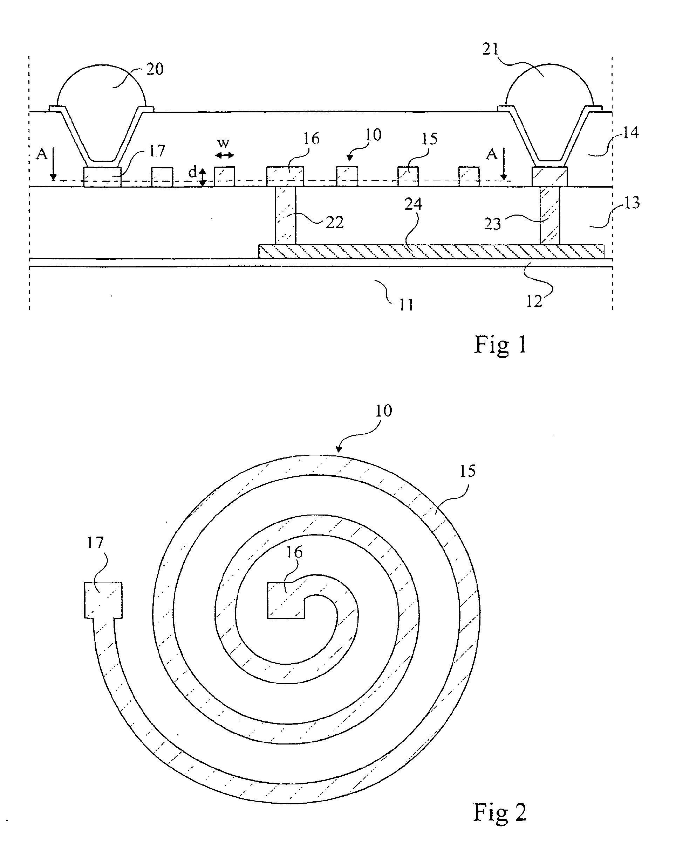

La figure 1 représente une coupe d'un circuit monolithique comprenant une inductance 10 réalisée de façon classique. Un substrat semiconducteur 11, par exemple en silicium, est recouvert d'un empilement d'une couche isolante 12, par exemple de l'oxyde de silicium, et de première et deuxième couches de passivation 13, 14. L'inductance 10 repose sur la surface extérieure de la première couche de passivation 13.

La figure 2 représente une coupe de l'inductance 10 selon les lignes A-A de la figure 1. L'inductance 10 se compose d'une piste conductrice 15 disposée en spirale et présentant des première 16 et deuxième 17 extrémités, la première extrémité 16 étant située sensiblement au centre de la spirale. La seconde extrémité 17 est reliée à un plot 20. La première extrémité 16 est reliée à un plot 21, par l'intermédiaire de vias 22, 23, formés dans la première couche de passivation 13, et d'une portion métallique 24 déposée sur la couche isolante 12. Les plots 20 et 21 font partie d'un ensemble de plots destinés au montage direct de la face supérieure du circuit monolithique sur un circuit imprimé.

L'inductance 10 est réalisée après la formation dans le substrat 11 d'éventuels composants actifs. L'inductance 10 peut être obtenue par le dépôt, sur la première couche de passivation 13, d'une couche métallique, par exemple de l'aluminium, recouverte d'un masque, et ensuite gravée de façon anisotrope. Les parties de la zone métallique non protégées par le masque forment la piste conductrice 15 et les extrémités 16, 17 de l'inductance 10. Finalement, la deuxième couche de passivation 14 est déposée et les plots 20 et 21 sont formés. La première couche de passivation 13 a entre autres pour rôle d'éloigner l'inductance 10 du substrat 11 afin de limiter les couplages entre ceux-ci.

L'inductance 10 possède une résistance série dont la formule est la suivante :

$$R = \rho \times \ell \ / \ S$$

où $\rho$ est la résistivité du matériau constituant l'inductance 10, $\ell$ la longueur de la piste conductrice 15 et S la surface de la section de la piste conductrice 15. De façon classique, la section de la piste conductrice 15 est sensiblement rectangulaire, et S est définie par $S = d \times w$ où d correspond à l'épaisseur de la piste conductrice 15, c'est-à-dire sensiblement l'épaisseur de métal déposée sur la première couche de passivation 13, et w la largeur de la piste conductrice 15 comme cela est représenté sur la figure 1. L'inductance 10 présente également un facteur de qualité qui correspond au rapport entre l'énergie échangée (l'énergie magnétique) et l'énergie perdue (les pertes ohmiques). Sa valeur est donnée, pour des fréquences inférieures à 500 Mhz, par la formule suivante :

$$Q = L \times \omega / R_{DC}$$

où $\omega$ est la pulsation du courant traversant l'inductance 10, L la valeur de l'inductance et $R_{DC}$ la résistance série équivalente de l'inductance en basse fréquence (c'est-à-dire pour des fréquences inférieures à 500 Mhz), qui est égale à la résistance série donnée par la formule ci-dessus.

Selon le procédé classique de formation d'une inductance 10 précédemment décrit, les valeurs de résistances série d'inductance 10 obtenues présentent une dispersion d'environ 5%, due aux dispersions cumulées à la fois par l'étape de dépôt de métal sur la première couche de passivation 13, et la gravure du métal. Cette dispersion entraîne une dispersion du facteur de qualité de l'inductance. De façon pratique, une telle dispersion peut provoquer des problèmes d'adaptation lors de l'utilisation ultérieure du circuit monolithique.

En outre, l'épaisseur d de l'inductance 10 est limitée à la fois par la technologie utilisée pour le dépôt du métal et par le fait que ce dépôt doit être recouvert par la deuxième couche de passivation 14. En effet, en raison de la présence de l'inductance 10, la surface sur laquelle est formée la deuxième couche de passivation 14 présente un relief irrégulier pouvant être à l'origine d'inhomogénéités de répartition de contraintes dans la deuxième couche de passivation 14, pouvant aboutir à des ruptures de couche. C'est pourquoi l'épaisseur d est, de façon générale, maintenue à moins de 3 $\mu$m. Ceci rend difficile l'obtention de valeurs de résistance série très faibles, et de facteurs de qualité élevés, si l'on ne veut pas augmenter la largeur w et donc la surface occupée par l'inductance.

La présente invention vise l'obtention d'une inductance de circuit monolithique pouvant présenter des épaisseurs élevées.

Elle vise également l'obtention d'une inductance facilitant la formation des couches de passivation.

Pour atteindre ces objets, la présente invention prévoit un procédé de fabrication d'une inductance dans un circuit monolithique comprenant un substrat de silicium de surface supérieure plane, comportant les étapes consistant à former dans le substrat une cavité suivant sensiblement le contour de l'inductance à former, la section de la cavité étant profonde par rapport à sa largeur ; former une région de silicium poreux au niveau de la cavité et oxyder ladite région de silicium poreux ; et remplir la cavité d'un matériau conducteur.

Selon une caractéristique de l'invention, la cavité est 5 à 10 fois plus profonde que large.

Selon une caractéristique de l'invention, la section de la cavité a une épaisseur supérieure à 10 $\mu$m et une largeur de l'ordre de 1 à 2 $\mu$m.

L'invention prévoit également une inductance formée dans un circuit monolithique, comprenant un substrat de silicium de surface supérieure plane, l'inductance étant au moins en partie logée dans une cavité du substrat, dont la section est profonde par rapport à sa largeur, et affleure la surface supérieure du substrat, et isolée du substrat par une région d'isolement consistant en une région de silicium poreux oxydé.

Ces objets, caractéristiques et avantages, ainsi que d'autres de la présente invention seront exposés en détail dans la description suivante faite à titre non-limitatif en relation avec les figures jointes parmi lesquelles :

la figure 1, précédemment décrite, représente une coupe d'un circuit monolithique comportant une inductance obtenue selon un procédé de fabrication classique ;
la figure 2, précédemment décrite, représente une coupe de la figure 1 selon les lignes A-A ;
les figures 3 à 5 représentent des coupes d'un circuit monolithique à différentes étapes du procédé de fabrication d'une inductance selon l'invention ; et
la figure 6 représente une coupe d'un circuit monolithique comportant une inductance selon le premier mode de réalisation de l'invention.

On notera que dans les différentes figures, comme cela est usuel dans le domaine de la représentation des circuits monolithiques, les épaisseurs et dimensions latérales des diverses couches ne sont pas tracées à l'échelle ni à l'intérieur d'une même figure ni d'une figure à l'autre pour améliorer la lisibilité de ces figures. Par ailleurs, de mêmes références désigneront de mêmes éléments de couche, éventuellement à des stades successifs de fabrication.

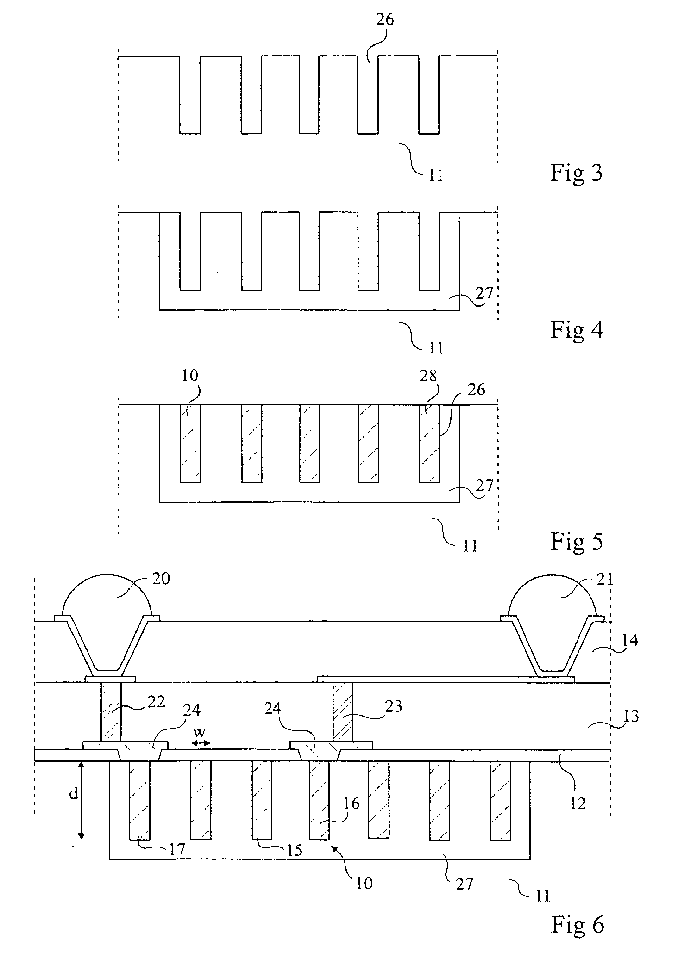

La figure 3 représente un substrat semiconducteur 11, par exemple en silicium, dans lequel on a formé une cavité 26 dont la profondeur est fonction de l'épaisseur d d'inductance 10 souhaitée. La cavité 26 peut être obtenue par une gravure anisotrope du substrat 11 recouvert d'un masque (non représenté) qui expose une partie du substrat 11 selon un motif ayant approximativement l'allure de la figure 2. La cavité 26 obtenue suit ainsi sensiblement le contour de l'inductance 10.

La figure 4 représente le substrat 11 dans lequel sont successivement réalisées une électrolyse localisée pour obtenir une zone de silicium poreux enveloppant la cavité 26, puis une oxydation de la zone poreuse pour former une région 27 isolante. Une couche de métal, par exemple de l'aluminium, est alors déposée dans la cavité 26. Un dépôt de cuivre peut également être obtenu par électrolyse.

La figure 5 représente la cavité 26 remplie du matériau métallique après une étape dite de planarisation de la surface du substrat 11 au niveau de l'inductance 10. La planarisation peut être réalisée par un procédé du type polissage mécano-chimique (CMP) dans lequel les portions de métal en saillie par rapport à la surface extérieure du substrat 11 sont retirées.

On obtient ainsi une inductance 10 intégrée au substrat 11, et isolée de celui-ci par la région d'isolement 27. L'ensemble formé par le substrat 11, la région d'isolement 27 et l'inductance 10 présente une surface supérieure sensiblement plane. A titre d'exemple, on peut réaliser selon la présente invention une inductance 10 présentant une épaisseur de 10 $\mu$m, et une largeur de 1,5 $\mu$m.

La figure 6 représente une coupe d'un circuit monolithique comprenant une inductance 10 réalisée selon le premier mode de réalisation de l'invention. Les extrémités 16, 17 de l'inductance 10 sont reliées à des plots 20, 21 par l'intermédiaire de vias 22, 23 et de portions métalliques de façon classique.

Par rapport à la structure représentée sur la figure 1, la présente invention comporte de nombreux avantages.

Un premier avantage résulte dans le fait que, l'inductance 10 étant intégrée au substrat 11, le dépôt des première et deuxième couches de passivation 13, 14 est facilité. En effet, l'inductance 10 ne participe plus aux irrégularités de surface à l'origine de la fragilisation de la deuxième couche de passivation 14. Ainsi, la deuxième couche de passivation est formée sur une surface plus régulière. En outre, la formation de l'inductance 10 au niveau du substrat 11 ne perturbe pas non plus la formation de la première couche de passivation 13 puisque l'ensemble formé par le substrat 11 et l'inductance 10 présente une surface extérieure sensiblement plane. On améliore ainsi la fiabilité du composant en diminuant le risque de cassure des passivations.

Un autre avantage de la présente invention est que l'inductance 10 peut présenter une épaisseur d importante par rapport à celle d'une inductance classique. En effet, les technologies actuellement utilisées permettent de graver profondément le substrat 11 par exemple sur une profondeur de 10 à 20 $\mu$m. Pour une même longueur $\ell$ d'inductance 10, en augmentant l'épaisseur d on diminue la résistance série et on obtient ainsi une inductance 10 à faible chute de tension et faibles pertes ohmiques. De plus, pour une résistance série constante et pour un nombre de tours donnés, l'augmentation de l'épaisseur d permet de réduire la largeur w et donc la longueur $\ell$, d'où il résulte une diminution la surface occupée par l'inductance 10 sur le substrat 11.

Un autre avantage de la présente invention est l'obtention d'un meilleur contrôle de l'épaisseur de l'inductance 10 lors de sa formation. On diminue ainsi la dispersion des résistances série, et, en conséquence, la dispersion du facteur de qualité des inductances 10.

Un autre avantage de la présente invention est que les couplages résistifs et capacitifs de l'inductance 10 avec le substrat 11 sont remarquablement minimisés.

L'inductance 10 est alors efficacement isolée du substrat 11 et le facteur de qualité amélioré.

Bien entendu, la présente invention est susceptible de diverses variantes et modifications qui apparaîtront à l'homme de l'art. En particulier, l'inductance peut ne pas être disposée en spirale mais agencée différemment. La section de la piste conductrice peut ne pas être rectangulaire.

**Revendications**

1. Procédé de fabrication d'une inductance (10) dans un circuit monolithique comprenant un substrat de silicium (11) de surface supérieure plane, **caractérisé en ce qu'**il comporte les étapes suivantes:

   - former dans le substrat (11) une cavité (26) suivant sensiblement le contour de l'inductance (10) à former, la section de la cavité étant profonde par rapport à sa largeur ;
   - former une région de silicium poreux (27) au niveau de la cavité (26) et oxyder ladite région de silicium poreux ; et
   - remplir la cavité (26) d'un matériau conducteur.

2. Procédé de fabrication d'une inductance selon la revendication 1, **caractérisé en ce que** la cavité (26) est 5 à 10 fois plus profonde que large.

3. Procédé de fabrication d'une inductance selon la revendication 2, **caractérisé en ce que** la section de la cavité (26) a une épaisseur supérieure à 10 $\mu$m et une largeur de l'ordre de 1 à 2 $\mu$m.

4. Inductance (10) formée dans un circuit monolithique, comprenant un substrat de silicium (11) de surface supérieure plane, au moins en partie logée dans une cavité (26) du substrat (11), dont la section est profonde par rapport à sa largeur, et affleure la surface supérieure du substrat (11), **caractérisée en ce qu'**elle est isolée du substrat (11) par une région d'isolement (27), consistant en une région de silicium poreux oxydé.

**Claims**

1. A method for manufacturing an inductance (10) in a monolithic circuit including a substrate (11) of planar upper surface, **characterized in that** it includes the steps of:

   - forming in the substrate (11) a cavity (26) substantially following the contour of the inductance (10) to be formed, the cross-section of the cavity being deep as compared to its width;
   - forming a porous silicon region (27) at the level of the cavity (26) and oxidizing said porous silicon region; and
   - filling the cavity (26) with a conductive material.

2. The method for forming an inductance of claim 1, **characterized in that** the cavity (26) is from 5 to 10 times deeper than it is wide.

3. The method for forming an inductance of claim 2, **characterized in that** the cross-section of the cavity (26) has a thickness greater than 10 $\mu$m and a width on the order of from 1 to 2 $\mu$m.

4. An inductance (10) formed in a monolithic circuit, including a silicon substrate (11) of planar upper surface, **characterized in that** it is at least partly housed in a cavity (26) of the substrate (11), the cross-section of which is deep as compared to its width, and levels the upper surface of the substrate (11), **characterized in that** it is insulated from the substrate (11) by an insulating region (27) consisting of an oxidized porous silicon region.

**Patentansprüche**

1. Ein Verfahren zur Herstellung einer Induktanz (10) in einer monolithischen Schaltung, die ein Substrat (11) mit einer planaren Oberseite umfasst, **dadurch gekennzeichnet, dass** das Verfahren die folgenden Schritte aufweist:

   Ausbilden eines Hohlraums (26) in dem Substrat (11), wobei der Hohlraum im Wesentlichen der Kontur der zu formenden Induktanz (10) folgt, wobei der Querschnitt des Hohlraums tief im Vergleich zu seiner Breite ist;
   Ausbilden eines porösen Siliziumbereichs (27) auf dem Niveau des Hohlraums (26) und Oxidieren des porösen Siliziumbereichs; und
   Füllen des Hohlraums (26) mit einem leitenden Material.

2. Verfahren zum Ausbilden einer Induktanz nach Anspruch 1, **dadurch gekennzeichnet, dass** der Hohlraum (26) 5 bis 10 mal tiefer als breit ist.

3. Verfahren zum Ausbilden einer Induktanz nach Anspruch 2, **dadurch gekennzeichnet, dass** der Querschnitt des Hohlraums (26) eine Dicke besitzt, die größer als 10 $\mu$m ist und eine Breite in der Größenordnung von 1 bis 2 $\mu$m.

4. Eine Induktanz (10), die in einem monolithischen Schaltkreis ausgebildet ist, der ein Siliziumsubstrat (11) mit einer planaren Oberseite umfasst, **dadurch gekennzeichnet, dass** die Induktanz wenigstens teilweise in einem Hohlraum (26) des Substrats (11) aufgenommen ist, der einen Querschnitt besitzt der im Vergleich zu seiner Breite tief ist, und auf einem Niveau mit der Oberseite des Substrats (11) liegt, **dadurch gekennzeichnet, dass** die Induktanz gegenüber dem Substrat (11) isoliert ist, und zwar über einen Isolierbereich (27) bestehend aus einem oxidierten porösen Siliziumbereich.

Fig 1

Fig 2

Fig 3

Fig 4

Fig 5

Fig 6